# EUROPEAN PATENT SPECIFICATION

(11) **EP 2 819 146 B1**
(45) Date of publication and mention of the grant of the patent: **01.11.2017**
(21) Application number: 14180524.2
(22) Date of filing: 18.08.2009
(51) Int. Cl.: H01J 37/20, B23Q 1/56

(54) **Charged particle beam lithography system and target positioning device**
Ladungsträgerstrahl-Lithografiesystem und -Zielpositionierungsvorrichtung
Système de lithographie à faisceau de particules chargées et dispositif de positionnement de cible

(30) Priority: 18.08.2008 NL 2001896; 18.08.2008 US 89744 P
(43) Date of publication of application: 31.12.2014
(62) Divisional of application: 09788279.9
(73) Proprietor: MAPPER LITHOGRAPHY IP B.V., 2628 XK Delft (NL)
(72) Inventor: Peijster, Jerry Johannes Martinus, 2628 XK DELFT (NL); De Boer, Guido, 4143 LN LEERDAM (NL)
(74) Representative: van de Wal, Barend Willem

(56) References cited:
- EP-A2- 1 107 067
- US-A- 5 806 193

## Description

### BACKGROUND

The present invention relates to a charged particle beam exposure system, such as a lithography system for maskless image projection, scanning and non-scanning electron microscopes, and the like.

Charged particle beam lithography systems, such as electron beam maskless lithography systems, are generally known and, relative to conventional mask based lithography systems, have the advantage of fabrication on demand as it were, due to an absence of the necessity to change and install masks or reticles. In stead, the image to be projected for the manufacture of integrated circuits is stored in a memory of a computer that controlles the maskless exposure system.

The known charged particle beam exposure systems commonly comprise a charged particle column placed in a vacuum chamber. The charged particle column comprises a charged particle source including a charged particle extraction means and electrostatic lens structures for the purpose of focussing and deflecting one or a multiplicity of charged particle beams on and over a target, such as a wafer. Furthermore the charged particle column comprises modulation means for modulating the one or multiplicity of charged particle beams, depending whether the image to be projected requires an exposure at a certain location or not.

During such projection the target is guided relative to the projection area of said charged particle column, by means of a stage that supports the target. For this new type of maskless lithography, appropriate stages have hardly been designed, at least are not commercially available. Known stages, for as far as they can be adapted to maskless lithography, are mostly inappropriate at least in the sense of e.g. size, costs and vacuum compatibility.

Also electromagnetic dispersion fields as commonly present at actuators, in particularly electro-magnetic actuators, are normally not desired in such systems, because any variation in electric of magnetic fields may affect the position of charged particle beams. It is known that fluctuations in electromagnetic fields due to an electromagnetic actuator can be reduced by arranging the electromagnetic actuator at a position remote from a target-bearing surface and providing a multiple shield in the electromagnetic actuator.

It is an object of the present invention to provide a charged particle beam lithography system comprising and an operating method using a target positioning device optimized for charged particle beam exposure of a target. A target positioning device in which flexures are used to fix a beam to carriages mounted on linear bases is disclosed in EP1107067.

### SUMMARY OF THE INVENTION

The present invention concerns a target positioning device as defined in claim 1 and a charged particle beam exposure system comprising that target positioning device. Further details and preferred embodiments are defined in the dependent claims. The various aspects and features described and shown in the specification can be applied, individually, wherever possible. These individual aspects, in particular the aspects and features described in the attached dependent claims, can be made subject of divisional patent applications.

### BRIEF DESCRIPTION OF THE DRAWINGS

The invention will be elucidated on the basis of an exemplary embodiment shown in the attached drawings, in which:
Figure 1 is a schematic illustration of a charged particle lithography system;
Figure 2 is a schematic plan view of a XY stage of a target positioning device according to the invention;
Figure 3 is a schematic view in cross-section along the line I-I in figure 2;
Figures 4A and 4B schematically show a displacement of the XY stage in the first or X direction;
Figures 5A - 5E schematically show a displacement of the XY stage in the second or Y direction;
Figure 6 schematically shows a cross-section of the XY stage during a displacement in the X-direction;
Figure 7 schematically shows a cross-section of the XY stage during a displacement in the Y-direction;
Figure 8 schematically shows a second exemplary embodiment of a XY stage of a target positioning device according to the invention;
Figure 9 schematically shows an exploded view of the XY stage of figure 8;
Figures 10A and 10B show a schematic plan view of the Y stage of figure 8; and
Figure 11 schematically shows a cross-section along the line A-A in figure 10A.

### DETAILED DESCRIPTION OF THE INVENTION

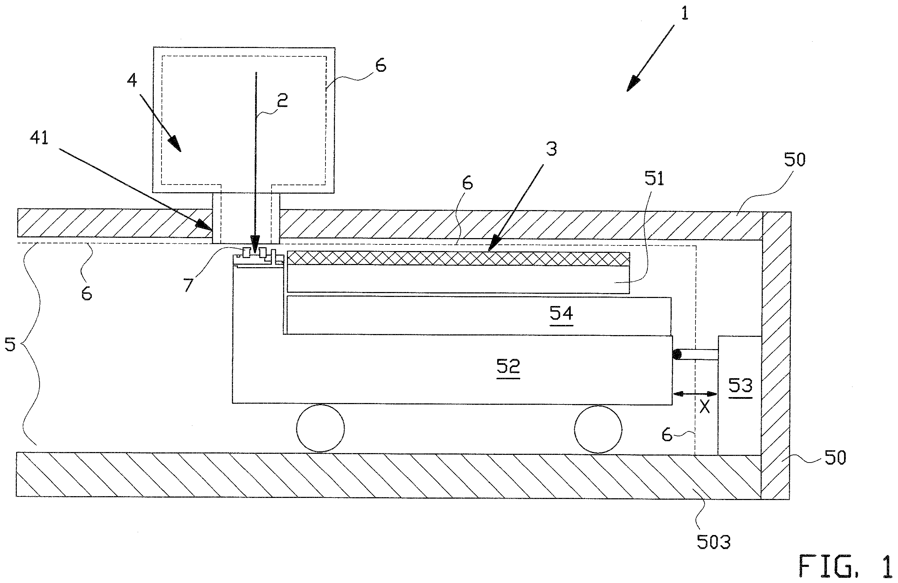

Figure 1 schematically shows a system 1 for charged particle beam lithography, using a massive array of parallel charged particle beams, so called cp-beams. In the present example the charged particle beams are electron beams. One of such cp-beams 2 is represented in figure 1.

All cp-beams are controlled separately by means of a modulator in a known manner, enabling a writing of a desired pattern on a target 3, in this case a wafer. The main advantages of this system compared to the commonly used optical systems are the writing of very small structures and the absence of expensive masks. The latter significantly reduces the start-up costs of a batch, making the present system highly advantageous for prototyping and medium volume production.

The system consists of three major subsystems, namely a data path subsystem (not shown in figure 1), a charged particle optical column 4, for example an electron-optical column, and a target positioning device 5.

The charged particle optical column 4 creates a massive array of predominantly parallel, focused cp-beams 2, emerging from the bottom of the column 4. Each cp-beam is controlled by said data path. In a manner known per se, the cp-beams are switched "on" and "off" and the positions of the cp-beams are adjusted within a small range in accordance with the data. In a final part of the charged particle optical column, in fact at a projection lens 41, the cp-beams 2 are deflected back and forth, substantially transversely to a first direction X of movement of the target or wafer module 51, so as to enable writing of features, alternatively denoted structures, on the target 3.

Due to the nature of cp-beams 2, their trajectory can be changed by magnetic and/of electric fields. In the charged particle optical column 4 this is used to control the cp-beams 2 and to project the cp-beams 2 onto the target 3. In order to shield the charged particle optical column 4 from ambient magnetic and/or electric fields, which might disturb the trajectories of the cp-beams 2 and thus induces a deviation from the desired location of the cp-beams 2 on the target 3, at least the charged particle optical column 4 is provided with a shielding 6 comprising one or more layers of a µ-metal. In the example as shown in figure 1, also the target positioning device 5 is placed inside the shielding 6. The shielding 6 is in a convenient manner arranged as a lining of the vacuum-chamber for the charged particle optical column 4 and the vacuum-chamber of the target positioning device 5. Such shielding is arranged to attenuate the earth magnetic field by a considerable extent. In the arrangement at stake, attenuation by a factor of approximately 1000 is realized.

The target positioning device 5 places a target 3 in the focal plane of the charged particle optical column 4 and moves it underneath. The target positioning device 5 comprises a target module 51 for holding a target and a stage assembly for moving the target in the first X-direction by means of a stage, further referred herein as x-stage 52, and in a second Y-direction by means of a carrier, further referred herein as y-stage 54. In this example the X-direction is substantially perpendicular to the Y-direction, and the X and Y-directions form a plane which is substantially perpendicular to the charged particle optical column 4.

As discussed above, during the writing of a pattern, the cp-beams 2 are deflected back and forth transversely to the X-direction and the target 3 is moved underneath along the X-direction by moving the x-stage 52 using the first actuator 53. Such a scan results in a writing path with a width which is determined by the extent of deflection of the cp-beams 2 in the deflection direction, and with a length which is determined by the length of travel of the x-stage 52. In particular the length of the writing path can extend over the whole target 3 area.

During the writing of each writing path, essentially only the first actuator needs to be driven. In order to shield the charged particle optical column 4 during the writing of a pattern from magnetic and/or electric fields from the first actuator 53, the first actuator 53 is arranged outside the shielding 6. Thus, the shielding means 6 for the optical column 4 can also be used for shielding the charged particle optical column 4 from magnetic and/or electric fields from the first actuator 53.

In the illustrative example as shown in figure 1, the first actuator 53 is arranged inside the vacuum chamber 50 of the target positioning device 5. Alternatively, the first actuator 53 may be arranged outside the vacuum chamber 50 of the target positioning device 5.

Furthermore, both the first actuator 53 and the stage 52 are rigidly connected with respect to each other. In the example shown in figure 1, both the first actuator 53 and the stage 52 are rigidly connected to a base plate 503. This rigid connection ensures that a proper alignment of the actuator or motor 53 with respect to the stage 52 is maintained. In an example, the base plate 503 is arranged to provide a highly stiff construction, preferably with a low coefficient of thermal expansion. In an example the base plate 503 comprises a granite slab or a granite table top.

During the writing of a writing path, thus when the cp-beams 2 are projected onto the target 3, essentially only the first actuator 53 is driven (except maybe for performing small corrections in a Z-direction, which is substantially perpendicular to the XY-plane). During any other movements, other than during writing, magnetic and/or electric fields and fluctuations therein are allowable. Thus the actuators for moving the target positioning device 5 in the Y- and/or Z-direction are placed inside the shielding 6 for the optical column 4.

When moving the target 3 along the Y-direction, for example for moving the target 3 towards a next writing path after a previous writing path has been written, the cp-beams 2 can be prevented to reach the target 3, for example by switching off the beams 2, and/or the target 3 can be moved to a location where the cp-beams 2 are outside the area on the target 3 which is to be illuminated by the cp-beams 2. During this movement in the Y-direction, magnetic and/or electric fields and fluctuations therein are allowable.

For example, the target positioning device 5 can be moved in X-direction, such that the cp-beams 2 fall onto a beam sensor 7, as shown in figure 1, which is placed on the x-stage 52 adjacent to the target table 51. During the movement in the Y-direction, the beam sensor 7 may be used for measuring characteristic properties of the cp-beams 2 prior to writing a next writing path.

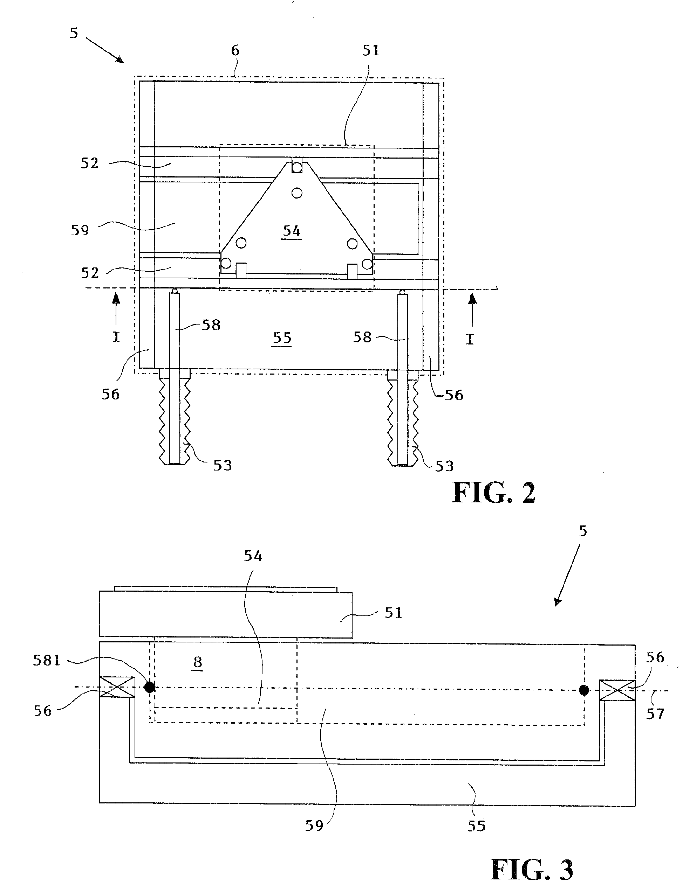

An example of the target positioning device 5 is shown in more detail in figures 2 and 3. In this example, the target positioning device 5 comprises a support frame 55 with two linear bearings 56 which extend in the X-direction. The level of the centre of gravity 57 of the target positioning device 5 lies in a plane through the bearings 56.

The bearings 56 support the x-stage 52 and allow for a smooth movement of the x-stage 52 along the X-direction. For driving the x-stage 52, two first or x-actuators 53 are provided. These x-actuators 53 are placed outside the shielding 6. Each of the x-actuators 53 comprises a push-pull rod 58 which extends through the shielding 6 and connects to the x-stage 52. As shown in figure 3, the point of application 581, where the x-actuator 53 via the push-pull rod 58 applies force to the x-stage 52 is positioned at the level of the centre of gravity 57 of the target positioning device 5.

On top of the x-stage 52, the y-stage 54 is placed. The y-stage 54 comprises a short stroke actuator 59 which will be described in more detail below.

On top of the y-stage 54, a target module 51 is placed. This target module 51 may be provided with a short stroke stage 8 with six degrees of freedom, on top of which a target table is placed for holding a target.

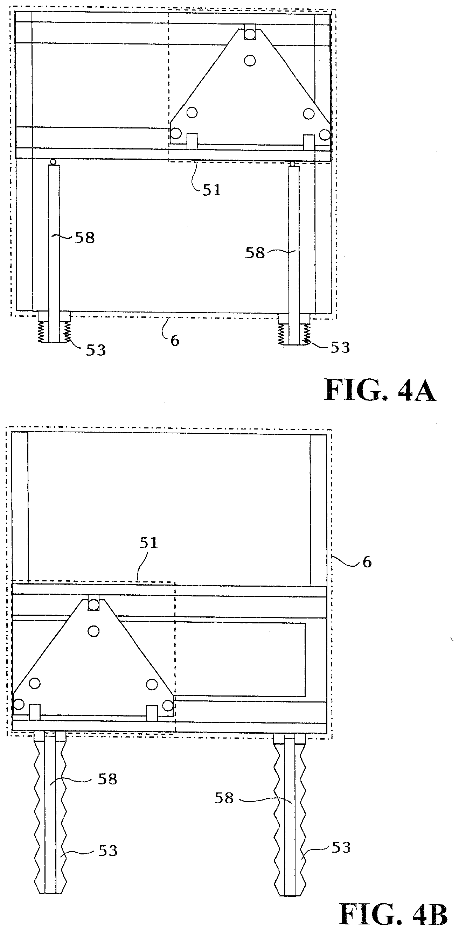

As shown in figures 4A en 4B, the target module 51 can be moved along the X-direction by extending or retracting the push-pull rods 58 by the first actuators 53.

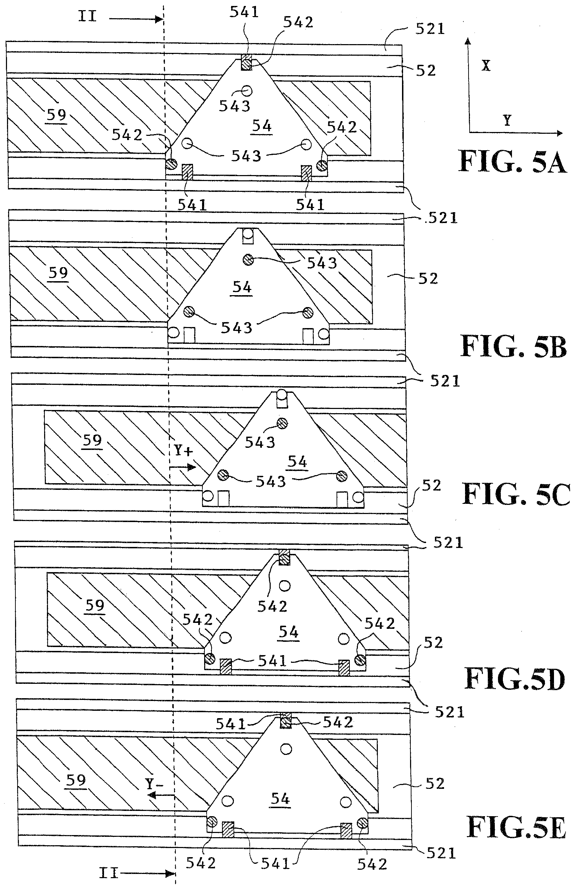

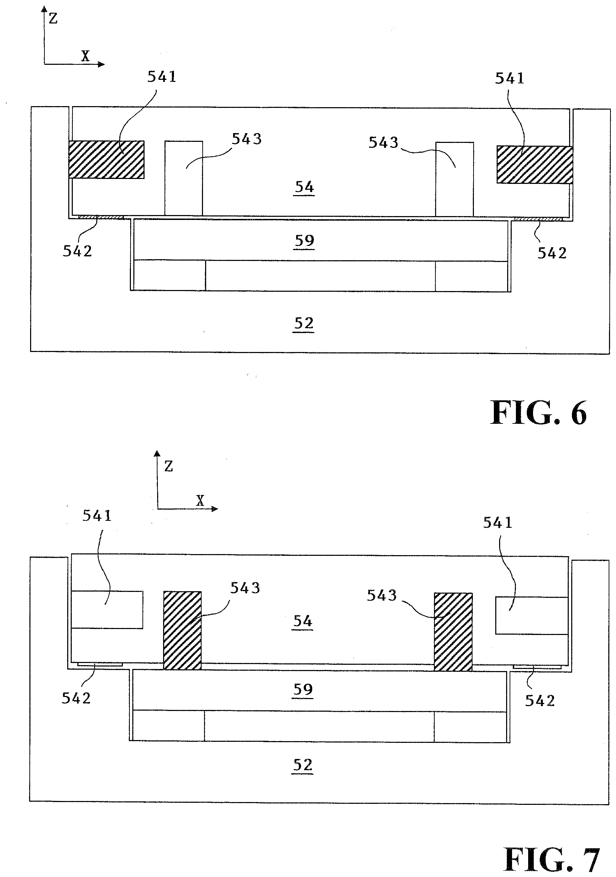

Figures 5A - 5E schematically show the functioning of the short stroke actuator 59 of the y-stage 54. Figures 6 and 7 schematically show a cross-section of the y-stage along the line II-II of figures 5A - 5E. Activated piezoelectric elements are presented with a shaded or hatched area in these figures.

When the x-stage 52 is driven for performing a writing of a pattern, the position of the target module 51 on the y-stage 54 is fixed and retained. In order to retain the position of target module 51 on the y-stage 54 with respect to the x-stage 52 in the Y-direction, the y-stage 54 is provided with first piezo-electric elements 541 which can be placed in a retaining position as shown in figures 6 and 5A, in which the piezo-electric elements 541 clamp the y-stage 54 between sidewalls 521 of the x-stage 52. In order to provide the correct position in the Z-direction, the y-stage 54 is provided with second piezo-electric elements 542 which can be placed in a supporting position as shown in figures 6 and 5A, in which the piezo-electric elements 542 rest on the x-stage 52.

For moving the y-stage 54 in the Y-direction, the first piezo-electric elements 541 are placed in a release position as shown in figures 7 and 5B, in which the piezo-electric elements 541 are retracted and do not provide a clamping force on the sidewalls 521 of the x-stage 52. Furthermore, the y-stage 54 is provided with third piezo-electric elements 543 which can be placed in a supporting position as shown in figures 7 and 5B, in which the piezo-electric elements 543 and thus the y-stage 54 rests on the short stroke actuator 59, and the y-stage 54 is coupled to the actuator 59 by the coupling means 543. Note that in the retained or locked position as shown in figures 6 and 5A, the third piezo-electric elements 543 are retracted and the y-stage 54 is not supported by the short stroke actuator 59.

When the y-stage 54 rests on the short stroke actuator 59, as shown in figure 5B, the actuator 59 can make a short stroke in the Y-direction, as shown in figure 5C. During this stroke, the actuator 59 thus moves the target module 51 on the y-stage 54 in the Y-direction.

After moving the y-stage 54 in the Y-direction over a desired distance Y+, the second piezo-electric elements 542 are extended, the third piezo-electric elements 543 are retracted and the y-stage 54 is now supported by the x-stage 54 by the second piezo-electric elements 542 and is free from the short stroke actuator 59. Subsequently the first piezo-electric elements 541 are placed in a retaining position, in which the piezo-electric elements 541 clamp the y-stage 54 between sidewalls 521 of the x-stage 52, as shown in figure 5D.

Subsequently, the short stroke actuator 59 may return to its original position by moving back over a distance Y-, which results in the same situation for the short stroke actuator 59 is shown in figure 5A.

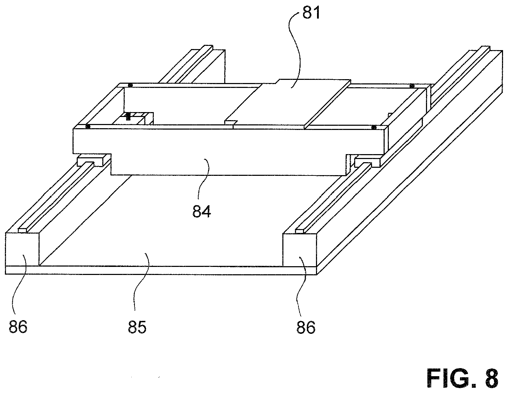

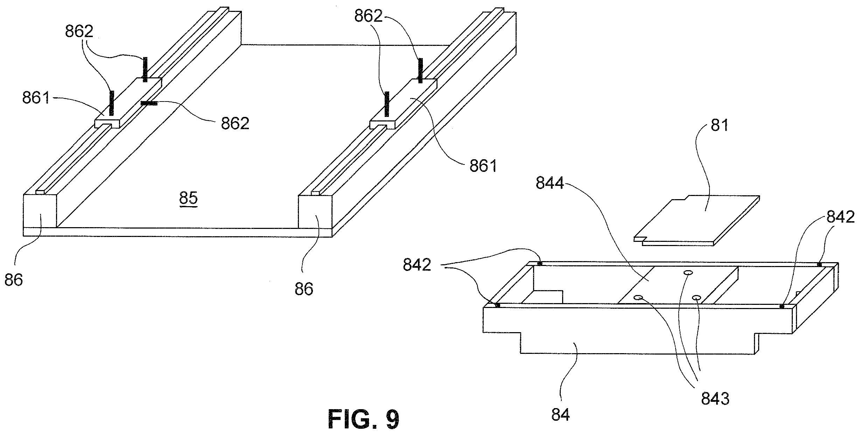

By repeating this procedure, the y-stage 54 can be moved stepwise along the Y-direction. When the short stroke actuator 59 initially is placed on the left-hand side, as shown in figure 5A, the y-stage 54 can be stepwise moved to the right. When the short stroke actuator 59 initially is placed on the right-hand side, as shown in figure 5D, the y-stage 54 can be stepwise moved to the left. According to the invention, as shown in figure 8, the XY-stage comprises two X-stage bases 86, both arranged on top of a common base plate 85. Each X-stage base 86 carries an X-stage carriage 861. The X-stage carriages 861 are provided with flextures 862 (see figure 9) for connecting a Y-beam 84 to the X-stage carriages 861. The Y-beam 84 bridges the space between the X-stages and is provided with interface members 842 for connecting to the fextures 862.

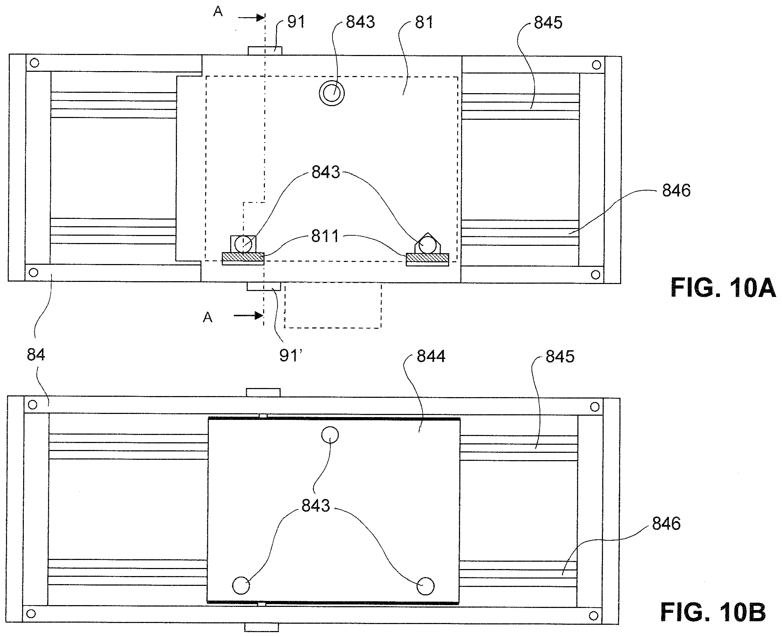

The Y-beam comprises a Y-stage having a Y-carriage 844 or carrier for carrying a target module (not shown). In particular, in use the target is arranged on top of a target module, and the target module is arranged on top of the Y-stage via an interface plate 81. The Y-carriage 844 or carrier is provided with interface pins 843, as shown in figure 10B, where the interface plate 81 is removed.

In particular the interface pins 843 may provide a kinematic mount in order to accurately position the target module on the carrier or Y-carriage 844. A mount is said to be kinematic when the number of degrees of freedom (axes of free motion) and the number physical constraints applied to the mount total six. The side of the interface plate 81 facing the Y-carriage 844 is therefore provided with a "cone, groove, and flat" mount schematically illustrated in Figure 10A, wherein the interface pins 843 are retained in the groove and cone respectively by resilient members or springs 811.

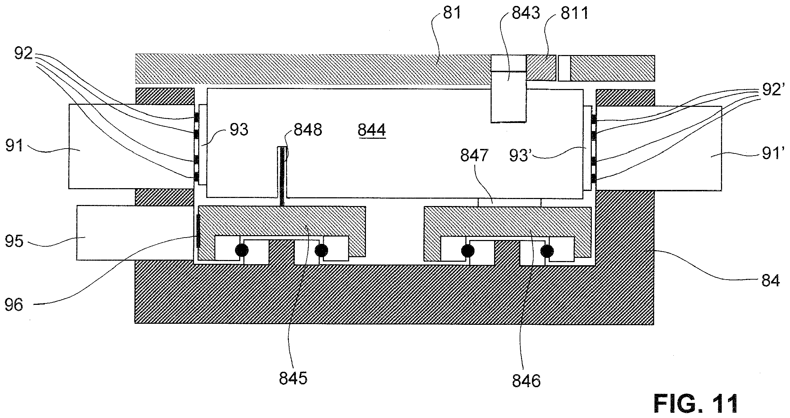

As shown in the cross-section of figure 11, the Y-beam 84 provides a common base plate for two parallel arranged linear stages 845, 846. The carriages of these stages 845, 846 are pre-stressed and provide for the required stiffness of the construction.

In this embodiment the Y-carriage 844 is on the one hand rigidly connected to the carriage of the first stage 846 via a rigid interface 847, and is on the other hand connected to the carriage of the second stage 845 via a flexture 848 in order to absorb any thermal expansion of the stages 845, 846 and/or the Y-carriage 844.

Furthermore, at least one of the stages 845, 846, in this embodiment the second stage 845 is used, is provided with a ruler 96, which in cooperation with a linear encoder head 95 can provide positional information of the Y-carriage in the second or Y-direction.

In this embodiment both opposite side faces of the Y-beam 84, which extent along the Y-direction, are provided with a piezoelectric motor 91, 91', which both have extending members 92, 92' which are driven via piezoelectric elements. The extending member 92, 92'may act on the adjacent ceramic driving plates 93, 93', which are arranged on opposite side faces of the Y-carriage 844, on the one hand for retaining the position of the Y-carriage 844 with respect to the Y-beam 84, and on the other hand for moving the Y-carriage 844 along the stages 845, 846 of the Y-beam 84. In this exemplary embodiment, the Y-carriage 844 or carrier is interposed and restrained between two opposing piezoelectric motors 91, 91'.

It is to be understood that the above description is included to illustrate the operation of the preferred embodiments and is not meant to limit the scope of the invention. From the above discussion, many variations will be apparent to one skilled in the art that would yet be encompassed by the scope of the present invention.

For example, in stead of using piezo-electric elements, also other actuator may be used for clamping and thus retaining the carrier to the stage. Such alternative actuators may comprise pneumatic, hydraulic or other types of mechanical actuators.

The target positioning device with the retaining means according to the invention can thus be suitably be arranged to minimize variation in electric of magnetic fields that may disturb the trajectories of the charged particle beams, and thus to optimize a target positioning device for use in a charged particle exposure system, such as a lithography system for mask less image projection, in particular a multi-beam charged particle exposure system.

## Claims

1. A target positioning device comprising a carrier for carrying a target, and an xy-stage having an x-stage for carrying and moving the carrier along a first direction (X),
wherein the carrier is displaceably arranged on the x-stage so that the carrier is displaceable relative to the x-stage along a second direction (Y) different from said first direction,
wherein said x-stage comprises two x-stage bases (86), both arranged on top of a common base plate (85), said x-stage further comprising two x-stage carriages (861), wherein each of said x-stage bases (86) carries one of said x-stage carriage (861),
said xy-stage further comprising a Y-beam (84) which bridges the space between the x-stage carriages (861), wherein said x-stage carriages (861) are provided with flexures (862) for connecting said Y-beam (84) to the x-stage carriages (861), wherein said Y-beam (84) is provided with interface members (842) for connecting to the flexures (862),
**characterized in that** each of said x-stage carriages (861) is provided with two flexures (862) which are spaced along the x-direction and positioned at opposite ends of the x-stage carriage (861) and extend substantially in a third direction normal to the first and the second direction.

2. Target positioning device according to claim 1, wherein the Y-beam (84) comprises a y-stage having a y-carriage (844) for carrying a target module (51), preferably wherein, in use, the target (3) is arranged on top of the target module (51) and the target module is arranged on top of the y-stage via an interface plate (81).

3. Target positioning device according to claim 2, wherein said Y-beam (84) provides a common base plate for a first linear stage (846) and a second linear stage (845), wherein said first linear stage (846) and said second linear stage (845) are arranged parallel to each other, wherein said y-carriage (844) is on the one hand rigidly connected to the carriage of said first linear stage (846) via a rigid interface (847), and is on the other hand connected to the carriage of said second linear stage (845) via a flexure (848) in order to absorb any thermal expansion of the stages (845, 846) and/or the y-carriage (844).

4. Target positioning device according to claim 2 or claim 3, wherein the interface members are interface pins which provide a kinematic mount in order to accurately position the target module on the y-carriage (844).

5. Target positioning device according to any one of the preceding claims, wherein one of said x-stage carriages further is provided with a third flexure (861) which extends in the second direction towards the opposite x-stage base.

6. Target positioning device according to any one of the preceding claims, further comprising retaining means for retaining the carrier with respect to the x-stage in a first relative position, wherein the retaining means comprises two opposing piezoelectric motors for moving the carrier in the second direction (Y), and wherein the carrier is interposed and/or restrained between said two opposing piezoelectric motors.

7. Target positioning device according to claim 6, wherein both opposite side faces of the Y-beam (84), which extend along a second direction (Y) perpendicular to said first direction (X), are each provided with one of said piezoelectric motors (91, 91'), wherein both said piezoelectric motors have extending members (92, 92') which are driven via piezoelectric elements.

8. Charged particle beam exposure system comprising a vacuum chamber and a charged particle optical column (4) arranged in said vacuum chamber for projecting a charged particle beam onto a target, wherein the column comprises deflecting means for deflecting the charged particle beam in a deflection direction,
**characterized in that** said charged particle beam lithography system comprises a target positioning device according to any one of the preceding claims which is arranged within the vacuum chamber, preferably wherein the first direction (X) is different from the deflection direction.

9. Charged particle beam exposure system according to claim 8, wherein said system is a charged particle beam lithography system.

## Patentansprüche

1. Eine Zielobjektpositionierungsvorrichtung, umfassend einen Träger zum Tragen eines Zielobjekts und eine XY-Plattform, aufweisend eine X-Plattform zum Tragen und Bewegen des Trägers entlang einer ersten Richtung (X),
wobei der Träger verschiebbar auf der X-Plattform angeordnet ist, so dass der Träger in Bezug auf die X-Plattform entlang einer zweiten Richtung (Y), die von der ersten Richtung verschieden ist, verschiebbar ist,
wobei die X-Plattform zwei X-Plattformsockel (86) umfasst, beide oben auf einer gemeinsamen Grundplatte (85) angeordnet, die X-Plattform des wieteren zwei X-Plattformschlitten (861) umfasst, wobei jeder der X-Plattformsockel (86) einen der X-Plattformschlitten (861) trägt,
die XY-Plattform des weiteren einen Y-Träger (84) umfasst, welcher den Raum zwischen den X-Plattformschlitten (861) überbrückt, wobei die X-Plattformschlitten (861) mit Biegeelementen (862) zum Verbinden des Y-Trägers (84) mit den X-Plattformschlitten (861) ausgestattet sind, wobei der Y-Träger (84) mit Verbindungselementen (842) zum Verbinden mit den Biegeelementen (862) versehen ist,
**dadurch gekennzeichnet, dass** jeder der X-Plattformschlitten (861) mit zwei Biegeelementen (862) ausgestattet ist, welche im Abstand entlang der X-Richtung und an gegenüberliegenden Enden des X-Plattformschlittens (861) angeordnet sind, und sich im Wesentlichen in einer dritten Richtung, senkrecht zu der ersten und der zweiten Richtung erstrecken.

2. Zielobjektpositionierungsvorrichtung gemäß Anspruch 1, wobei der Y-Träger (84) eine Y-Plattform aufweisend einen Y-Schlitten (844) zum Tragen eines Zielobjektmoduls (51) umfasst, wobei vorzugsweise im Einsatz das Zielobjekt (3) oben auf dem Zielobjektmodul (51) angeordnet ist und das Zielobjektmodul über eine Verbindungsplatte oben auf der Y-Plattform angeordnet ist.

3. Zielobjektpositionierungsvorrichtung gemäß Anspruch 2, wobei der Y-Träger (84) eine gemeinsame Grundplatte für eine erste Linearplattform (846) und eine zweite Linearplattform (845) bereitstellt, wobei die erste Linearplattform (846) und die zweite Linearplattform (845) parallel zueinander angeordnet sind, wobei der Y-Schlitten (844) einerseits über ein starres Verbindungselement (847) starr mit dem Schlitten der ersten Linearplattform (846) verbunden ist, und andererseits über ein Biegeelement (848) mit dem Schlitten der zweiten Linearplattform (845) verbunden ist, um jegliche thermische Ausdehnung der Plattformen (845, 846) und / oder des Y-Schlittens (844) zu absorbieren.

4. Zielobjektpositionierungsvorrichtung gemäß Anspruch 2 oder Anspruch 3, wobei die Verbindungselemente Verbindungsstifte sind, welche eine kinematische Halterung bereitstellen, um das Zielobjektmodul präzise auf dem Y-Schlitten (844) zu positionieren.

5. Zielobjektpositionierungsvorrichtung gemäß einem der vorhergehenden Ansprüche, wobei einer der X-Plattformschlitten des weiteren mit einem dritten Biegeelement (861) ausgestattet ist, welches sich in der zweiten Richtung zu dem gegenüberliegenden X-Plattformsockel erstreckt.

6. Zielobjektpositionierungsvorrichtung gemäß einem der vorhergehenden Ansprüche, umfassend des weiteren Haltemittel zum Halten des Trägers in einer ersten relativen Position in Bezug auf die X-Plattform, wobei die Haltemittel zwei gegenüberliegende piezoelektrische Motoren zum Bewegen des Trägers in der zweiten Richtung (Y) umfassen, und wobei der Träger zwischen den zwei gegenüberliegenden piezoelektrischen Motoren eingefügt und / oder gehalten wird.

7. Zielobjektpositionierungsvorrichtung gemäß Anspruch 6, wobei beide gegenüberliegenden Stirnflächen des Y-Trägers (84), die sich entlang einer zweiten Richtung (Y) senkrecht zu der ersten Richtung (X) erstrecken, jeweils mit einem der piezoelektrischen Motoren (91, 91') ausgestattet sind, wobei beide der piezoelektrischen Motoren Ausdehnungselemente (92, 92') aufweisen, welche über piezoelektrische Elemente betrieben werden.

8. Belichtungssystem mit einem Strahl geladener Teilchen, umfassend eine Vakuumkammer und eine optische Säule (4) für geladene Teilchen, angeordnet in der Vakuumkammer zum Projizieren eines Strahls geladener Teilchen auf ein Zielobjekt, wobei die Säule Ablenkungsmittel zum Ablenken des Strahls geladener Teilchen in eine Ablenkungsrichtung umfasst,
**dadurch gekennzeichnet, dass** das Lithografiesystem mit einem Strahl geladener Teilchen eine Zielobjektpositionierungsvorrichtung gemäß einem der vorhergehenden Ansprüche umfasst, welche innerhalb der Vakuumkammer angeordnet ist, wobei sich vorzugsweise die erste Richtung (X) von der Ablenkungsrichtung unterscheidet.

9. Belichtungssystem mit einem Strahl geladener Teilchen gemäß Anspruch 8, wobei das System ein Lithografiesystem mit einem Strahl geladener Teilchen ist.

## Revendications

1. Dispositif de positionnement de cible comprenant un moyen de support pour supporter une cible, et un support xy qui comporte un support x pour supporter et déplacer le moyen de support suivant une première direction (X), dans lequel :
le moyen de support est agencé de manière à pouvoir être déplacé sur le support x de telle sorte que le moyen de support puisse être déplacé par rapport au support x suivant une deuxième direction (Y) qui est différente de ladite première direction,
dans lequel ledit support x comprend deux bases de support x (86) qui sont toutes deux agencées sur le dessus d'une plaque de base commune (85), ledit support x comprenant en outre deux chariots de support x (861), dans lequel chacune desdites bases de support x (86) supporte l'un desdits chariots de support x (861),
ledit support xy comprenant en outre une poutre Y (84) qui enjambe l'espace entre les chariots de support x (861), dans lequel lesdits chariots de support x (861) sont munis d'éléments de flexion (862) pour connecter ladite poutre Y (84) aux chariots de support x (861), dans lequel ladite poutre Y (84) est munie d'éléments d'interface (842) pour une connexion aux éléments de flexion (862),
**caractérisé en ce que** chacun desdits chariots de support x (861) est muni de deux éléments de flexion (862) qui sont espacés suivant la direction x et qui sont positionnés à des extrémités opposées du chariot de support x (861) et qui s'étendent sensiblement dans une troisième direction qui est normale aux première et deuxième directions.

2. Dispositif de positionnement de cible selon la revendication 1, dans lequel la poutre Y (84) comprend un support y qui comporte un chariot y (844) pour supporter un module de cible (51), de préférence dans lequel, en utilisation, la cible (3) est agencée sur le dessus du module de cible (51) et le module de cible est agencé sur le dessus du support y via une plaque d'interface (81).

3. Dispositif de positionnement de cible selon la revendication 2, dans lequel ladite poutre Y (84) constitue une plaque de base commune pour un premier support linéaire (846) et un second support linéaire (845), dans lequel ledit premier support linéaire (846) et ledit second support linéaire (845) sont agencés parallèlement l'un à l'autre, dans lequel chariot y (844) est d'une part connecté de manière rigide au chariot dudit premier support linéaire (846) via une interface rigide (847) et est d'autre part connecté au chariot dudit second support linéaire (845) via un élément de flexion (848) de manière à absorber une quelconque dilatation thermique des supports (845, 846) et/ou du chariot y (844).

4. Dispositif de positionnement de cible selon la revendication 2 ou la revendication 3, dans lequel les éléments d'interface sont des broches d'interface qui assurent un montage cinématique de manière à positionner de façon précise le module de cible sur le chariot y (844).

5. Dispositif de positionnement de cible selon l'une quelconque des revendications précédentes, dans lequel l'un desdits chariots de support x est en outre muni d'un troisième élément (861) de flexion qui s'étend dans la deuxième direction en direction de la base de support x opposée.

6. Dispositif de positionnement de cible selon l'une quelconque des revendications précédentes, comprenant en outre un moyen de retenue pour retenir le moyen de support par rapport au support x dans une première position relative, dans lequel le moyen de retenue comprend deux moteurs piézoélectriques opposés pour déplacer le moyen de support dans la deuxième direction (Y) et dans lequel le moyen de support est interposé et/ou encastré entre lesdits deux moteurs piézoélectriques opposés.

7. Dispositif de positionnement de cible selon la revendication 6, dans lequel les deux faces latérales opposées de la poutre Y (84), qui s'étendent suivant une deuxième direction (Y) qui est perpendiculaire à ladite première direction (X), sont chacune munies de l'un desdits moteurs piézoélectriques (91, 91'), dans lequel lesdits moteurs piézoélectriques comportent tous deux des éléments d'extension (92, 92') qui sont entraînés via des éléments piézoélectriques.

8. Système d'exposition par faisceau de particules chargées, comprenant une chambre sous vide et une colonne optique de particules chargées (4) qui est agencée dans ladite chambre sous vide pour projeter un faisceau de particules chargées sur une cible, dans lequel la colonne comprend un moyen de déviation pour dévier le faisceau de particules chargées dans une direction de déviation, **caractérisé en ce que** ledit système de lithographie par faisceau de particules chargées comprend un dispositif de positionnement de cible selon l'une quelconque des revendications précédentes qui est agencé à l'intérieur de la chambre sous vide, de préférence dans lequel la première direction (X) est différente de la direction de déviation.

9. Système d'exposition par faisceau de particules chargées selon la revendication 8, dans lequel ledit système est un système de lithographie par faisceau de particules chargées.
